# EUROPÄISCHE PATENTSCHRIFT

(11) **EP 2 160 086 B1**
(45) Veröffentlichungstag und Bekanntmachung des Hinweises auf die Patenterteilung: **06.09.2017**
(21) Anmeldenummer: 09164380.9
(22) Anmeldetag: 02.07.2009
(51) Int. Cl.: F28F 27/02, H05K 7/20

(54) **KÜHLVORRICHTUNG ZUR KÜHLUNG EINES ELEKTRONISCHEN STEUERGERÄTS SOWIE EIN ELEKTRONISCHES STEUERGERÄT**
COOLING DEVICE FOR COOLING AN ELECTRONIC CONTROL DEVICE AND AN ELECTRONIC CONTROL DEVICE
DISPOSITIF DE REFROIDISSEMENT DESTINÉ AU REFROIDISSEMENT D'UN APPAREIL DE COMMANDE ÉLECTRONIQUE ET APPAREIL DE COMMANDE ÉLECTRONIQUE

(30) Priorität: 29.08.2008 DE 102008041694
(43) Veröffentlichungstag der Anmeldung: 03.03.2010
(73) Patentinhaber: Robert Bosch GmbH, 70442 Stuttgart (DE)
(72) Erfinder: Dagenbach, Stefan, 75428 Illingen (DE)

(56) Entgegenhaltungen:
- JP-A- 2 052 991
- JP-A- 10 220 635
- US-A1- 2002 062 750

## Beschreibung

Die Erfindung betrifft ein elektronisches Steuergerät, insbesondere eines Kraftfahrzeugs, welches in einem Gehäuse mit mindestens einer Einströmöffnung für einen von einem Belüftungs- und/oder Klimatisierungssystem erzeugten Kühlluftstrom angeordnet ist.

### Stand der Technik

Die Leistungsaufnahme vieler elektronischer Steuergeräte, insbesondere im Kraftfahrzeugbereich, macht es erforderlich, die durch Verlustleistung des Steuergeräts erhöhte Temperatur in dem Gerät durch aktive Kühlmaßnahmen auf ein zulässiges Maß zu begrenzen. Aus dem Stand der Technik sind verschiedenartige Kühlvorrichtungen zur Kühlung von Steuergeräten bekannt. Beispielsweise können in ein Gehäuse des Steuergeräts integrierte Lüfter und/oder externe Lüfter, die über ein Leitungssystem angeschlossen sind, eingesetzt werden. Der Kühlluftbedarf kann bei dieser Variante von dem Steuergerät selbst gesteuert und/oder geregelt werden. Alternativ kann das Steuergerät mit einem in dem Fahrzeug vorhandenen Belüftungs- und/oder Klimatisierungssystem verbunden werden. Zu diesem Zweck können in dem Gehäuse des Steuergeräts Einströmöffnungen vorgesehen werden, durch welche über Belüftungskanäle einem Einbauraum des Steuergeräts zugeführte Kühlluft in das Gehäuse gelangen kann. Dabei wird der Einbauraum durch- beziehungsweise das Gehäuse umströmt. Diese Vorgehensweise bietet gegenüber den vorstehend beschriebenen aktiven Kühlmaßnahmen den Vorteil, dass kein zusätzlicher Lüfter benötigt wird und sie somit kostengünstiger ist. Es ist jedoch nachteilig, dass eine Steuerung und/oder Regelung des Kühlluftstroms in Abhängigkeit von dem Bedarf des Steuergeräts nicht vorgenommen werden kann, weil die Funktion des Belüftungs- und/oder Klimatisierungssystem nicht beeinflusst werden soll.

### Offenbarung der Erfindung

Demgegenüber weist das Elektronische Steuergerät mit den in Anspruch 1 genannten Merkmalen den Vorteil auf, dass kein zusätzlicher Lüfter für das Steuergerät vorgesehen werden muss und eine Steuerung und/oder Regelung des Kühlluftstroms durchführbar ist. Dies wird erreicht, indem der Volumenstrom der durch die Einströmöffnung einströmenden Kühlluft mittels eines die Einströmöffnung einstellbar überdeckenden Abdeckelements steuer- und/oder regelbar ist, wobei das Einstellen der Überdeckung der Einströmöffnung mittels eines thermischen Stellelements erfolgt. Das Steuergerät kann also mittels eines Kühlluftstroms gekühlt werden, welcher durch die Einströmöffnung des Gehäuses in dieses einströmen kann. Die Einströmöffnung ist beispielsweise über eine Leitung beziehungsweise ein Leitungssystem mit dem Belüftungs- und/oder Klimatisierungssystem verbunden. Über die Leitung beziehungsweise das Leitungssystem kann das Gehäuse mit Kühlluft versorgt werden beziehungsweise diese in das Innere des Gehäuses einströmen. Es kann jedoch auch vorgesehen sein, dass das Gehäuse von dem Kühlluftstrom des Belüftungs- und/oder Klimatisierungssystems umströmt wird, wobei der Kühlluftstrom zumindest teilweise durch die Einströmöffnung in das Innere des Gehäuses zur Kühlung des Steuergeräts gelangen kann. Der Volumenstrom der Kühlluft, welcher durch die Einströmöffnung einströmt, kann mittels des Abdeckelements gesteuert und/oder geregelt werden. Das bedeutet, dass dem Steuergerät Kühlluft je nach Bedarf zugeführt werden kann. Es ist daher möglich, das Steuergerät nur dann mit Kühlluft zu versorgen, beziehungsweise diese durch das Gehäuse zu leiten, wenn das Steuergerät Kühlbedarf aufweist. Damit wird das Risiko des Fremdstoffeintrags in das Gehäuse auf ein Minimum reduziert. Beispielsweise kann so verhindert werden, dass Staub in das Gehäuse gelangt. Zudem wird verhindert, dass beispielsweise über eine Kraftstoffzusatzheizung im Stand des Kraftfahrzeugs angewärmte feuchte Luft an das noch kalte Steuergerät gelangen kann, wobei es zur Bildung von Kondenswasser kommen würde. Das erfindungsgemäße elektronische Steuergerät bietet somit nicht nur eine Steuer- und/oder regelbare Kühlung des Steuergeräts,

Aus der JP 02-052991 A ist ein temperaturabhängig arbeitendes Bimetallventil bekannt, dass in einem Primär-Kühlkreislauf eines Kernreaktors integriert ist. In Abhängigkeit von der Temperatur des Primär-Kühlmittels öffnet das BimetallVentil das Ventil, um bei hohen Temperaturen zu erzwingen, dass das Kühlmittel durch den Wärmetauscher zu dem Sekundär-Kühlkreislauf des Kernreaktors geführt wird. Bei niedrigen Temperaturen öffnet das Ventil, um den Wärmetauscher zu dem Sekundär-Kühlkreislauf des Kernreaktors aus dem Primär-Kühlkreislauf des Kernreaktors auszuschließen.

sondern verhindert auch Beschädigungen, indem Fremdstoffeintrag und Kondenswasserbildung an dem Steuergerät verringert werden. Das Einstellen der Überdeckung erfolgt mittels des thermischen Stellelements. Das thermische Stellelement setzt einen Wärmeeintrag in mechanische Stellarbeit um. Beispielsweise dehnt sich das Stellelement mit steigender Temperatur aus oder zieht sich zusammen. Es kann vorgesehen sein, dass das thermische Stellelement das Abdeckelement bei einer niedrigen Temperatur des Steuergeräts die Einströmöffnung überdeckend anordnet, während bei einer hohen Temperatur das Abdeckelement die Einströmöffnung zumindest bereichsweise freigibt. Die zur Betätigung des thermischen Stellelements erforderliche Wärme, das heißt thermische Energie, entsteht beispielsweise über eine Verlustleistung des elektronischen Steuergeräts und einer damit verbundenen Eigenerwärmung desselben.

Eine Weiterbildung der Erfindung sieht vor, dass eine Bewegungsrichtung des Abdeckelements zum Einstellen der Überdeckung senkrecht oder parallel zu einer Hauptströmungsrichtung des Kühlluftstroms, insbesondere durch die Einströmöffnung, vorgesehen ist. Das Abdeckelement kann also beispielsweise in einer zu der Einströmöffnung parallelen Ebene bewegt werden. Dies bedeutet ein seitliches Verschieben des Abdeckelements beispielsweise parallel zu einer Wand des Gehäuses, in welcher die Einströmöffnung angeordnet ist. Alternativ kann sich das Abdeckelement von der Wand des Gehäuses entfernen beziehungsweise sich dieser wieder annähern, indem es sich parallel zu der Hauptströmungsrichtung des Kühlluftstroms bewegt. Dabei ist die Hauptströmungsrichtung des Kühlluftstroms durch die Einströmöffnung verlaufend definiert. Das bedeutet, dass die Strömungsrichtung des durch die Einströmöffnung einströmenden Kühlluftstroms herangezogen wird. Selbstverständlich ist auch eine Bewegungsrichtung des Abdeckelements möglich, welche zwischen der senkrechten und der parallelen Bewegungsrichtung liegt.

Eine Weiterbildung der Erfindung sieht vor, dass das Abdeckelement und/oder das thermische Stelleelement innerhalb des Gehäuses angeordnet sind. Diese Anordnung ist besonders vorteilhaft, da sich die Temperatur des Abdeckelements und/oder des thermischen Stellelements an die in dem Gehäuse vorliegende Temperatur angleicht. Auf diese Weise wird erreicht, dass das Einstellen der Überdeckung der Einströmöffnung unmittelbar in Abhängigkeit von dem von dem Steuergerät benötigten Kühlluftstrom erfolgen kann. Es sind also keine Hilfsmittel notwendig, um beispielsweise die Stellkraft des Stellelements zu einem außerhalb des Gehäuses angeordneten Abdeckelements zu führen beziehungsweise das thermische Stellelement mit geeigneten Hilfsmitteln an die in dem Gehäuse vorherrschende Temperatur anzugleichen. Es ist daher besonders vorteilhaft, wenn sowohl das Abdeckelement als auch das thermische Stellelement innerhalb des Gehäuses angeordnet sind.

Eine Weiterbildung der Erfindung sieht vor, dass das thermische Stellelement, insbesondere wärmeleitfähig, mit dem Gehäuse und/oder Steuergerät verbunden und/oder an dem Gehäuse und/oder Steuergerät befestigt ist. Das Stellelement ist also an das Gehäuse und/oder Steuergerät angebunden. Auf diese Weise kann es eine Relativbewegung des Abdeckelements hinsichtlich des Gehäuses und/oder Steuergeräts bewirken. Dies gilt auch analog für eine Befestigung des Stellelements an dem Gehäuse und/oder Steuergerät. Es ist vorteilhaft, wenn das Stellelement wärmeleitfähig mit dem Gehäuse und/oder Steuergerät verbunden ist. Auf diese Weise kann Wärme des Steuergeräts und/oder des Gehäuses nicht nur durch Konvektion, sondern auch durch Wärmeleitung an das Stellelement übertragen werden. Auf diese Weise kann eine besonders kurze Reaktionszeit des Stellelements realisiert sein.

Eine Weiterbildung der Erfindung sieht vor, dass das Abdeckelement eine Klappe oder ein Schieber ist. Das Abdeckelement kann beispielsweise Führungselemente aufweisen, welche an dem Gehäuse angeordnet sein können. So sind verschiedene Ausführungsformen des Abdeckelements realisierbar. Ist das Abdeckelement um eine Achse verdrehbar an dem Gehäuse angeordnet, so liegt ein klappenartiges Abdeckelement vor. Der Schieber kann beispielsweise über schienenartige Führungselemente realisiert sein, in welchen das Abdeckelement verschiebbar angeordnet ist.

Eine Weiterbildung der Erfindung sieht vor, dass das thermische Stellelement eine zum Einstellen der Überdeckung verwendete temperaturabhängige Deformation aufweist. Das Stellelement verändert also seine Abmessungen und/oder seine Form in Abhängigkeit der Temperatur. Zum Beispiel kann eine Veränderung der Länge des Stellelements auftreten. Das Stellelement ist so zu wählen, dass die Deformation in einem definierten Temperaturbereich, beispielsweise zwischen einer Minimal- und einer Maximaltemperatur, ausreichend ist, um das Abdeckelement in einem gewünschten Bereich zu bewegen. Beispielsweise soll eine Bewegung von einem vollständig geschlossenen Zustand zu einem vollständig geöffneten Zustand möglich sein, das heißt, dass das Abdeckelement in ersterem Fall die Einströmöffnung vollständig verschließt, während in letzterem Fall die Einströmöffnung von dem Kühlluftstrom passiert werden kann.

Eine Weiterbildung der Erfindung sieht vor, dass das thermische Stellelement eine vorbestimmbare Charakteristik zum zumindest teilweisen Öffnen oder Verschließen der Einströmöffnung mit dem Abdeckelement aufweist. Die Charakteristik des Stellelements beschreibt dabei die Formänderung beziehungsweise die Verlagerung des Abdeckelements mit der Temperatur. Es kann beispielsweise vorgesehen sein, dass ein Übergang von einem vollständig geschlossenen Zustand zu einem zumindest teilweise geöffneten Zustand der Einströmöffnung in einem engen Temperaturbereich erfolgt, während ein weiteres Öffnen vergleichsweise langsam erfolgt. Demgegenüber kann natürlich auch vorgesehen sein, dass zunächst eine geringe Bewegung des Abdeckelements über einen großen Temperaturbereich und eine weitere, größere Bewegung über einen engen Temperaturbereich erfolgt. Das thermische Stellelement kann auch einen hystereseartigen Verlauf über die Temperatur aufweisen. Das bedeutet, dass beispielsweise bei einem Anstieg der Temperatur die Überdeckung der Einströmöffnung bei gleicher Temperatur anders eingestellt wird als bei sinkender Temperatur.

Eine Weiterbildung der Erfindung sieht vor, dass das thermische Stellelement ein Thermobimetall, eine Formgedächtnislegierung oder einen Dehnstoff aufweist oder daraus besteht. Das thermische Stellelement weist also einen Werkstoff auf, welcher sich mit sich verändernder Temperatur verformt. Eine Möglichkeit dies zu realisieren ist ein Thermobimetall. Dieses besteht aus mindestens zwei Schichten unterschiedlichen Materials, die stoff- und/oder formschlüssig miteinander verbunden sind. Durch die unterschiedlichen Wärmeausdehnungkoeffizienten der verwendeten Materialien resultiert eine Auslenkung des Thermobimetalls, sobald die Temperatur von einer Referenztemperatur des Thermobimetalls abweicht. Weiterhin kann eine Formgedächtnislegierung vorgesehen sein. Diese kehren unter Temperatureinfluss nach einer Verformung in ihren ursprünglichen Zustand zurück. Das thermische Stellelement kann auch einen Dehnstoff aufweisen und beispielsweise als Dehnstoffarbeitselement ausgebildet sein. Dehnstoff dehnt sich bei Erwärmung stark aus, womit das Volumen vergrößert wird. Diese Volumenzunahme wird im Falle eines Dehnstoffarbeitselements auf einen Arbeitskolben übertragen, der sich daraufhin aus dem Dehnstoffarbeitselement herausbewegt und eine Stellfunktion ausübt. Das Dehnstoffarbeitselement weist üblicherweise ein Federelement auf, welches bei Abkühlung den Arbeitskolben zurückverlagert.

Eine Weiterbildung der Erfindung sieht vor, dass das Gehäuse von dem Kühlluftstrom umströmt ist. Das Gehäuse ist somit zumindest teilweise in dem Kühlluftstrom angeordnet. Auf diese Weise kann das Gehäuse zusätzlich konvektiv gekühlt sein. Durch die Anströmung des Gehäuses wird auch ein Einströmen des Kühlluftstroms durch die Einströmöffnungen bewirkt. Die Kühlluft kann von dem Belüftungs- und/oder Klimatisierungssystem in eine Umgebung des Gehäuses geführt sein und dort in Richtung des Gehäuses ausströmen.

Eine Weiterbildung der Erfindung sieht vor, dass das thermische Stellelement von einer Verlustleistung des Steuergeräts erwärmbar ist. Die Verlustleistung des Steuergeräts soll unmittelbar oder mittelbar auf das thermische Stellelement übertragbar sein. Die Verlustleistung ruft eine Temperaturerhöhung des Steuergeräts hervor, so dass es wünschenswert ist, eine Kühlleistung zu erhöhen. Daher soll die entstehende Wärme auf das thermische Stellelement übertragen werden, so dass dieses die Überdeckung der Einströmöffnung durch Einstellen des Abdeckelements so einstellen kann, dass ein größerer Volumenstrom der Kühlluft durch die Einströmöffnung in das Gehäuse gelangen kann, wodurch die Kühlung des Steuergeräts erhöht und die durch die Verlustleistung entstandene Wärme abtransportiert werden kann.

Die Erfindung umfasst ferner ein elektronisches Steuergerät, insbesondere gemäß den vorstehenden Ausführungen, mit einem Gehäuse mit mindestens einer Einströmöffnung für einen von einem Belüftungs- und/oder Klimatisierungssystem erzeugten Kühlluftstrom. Es ist vorgesehen, dass der Volumenstrom der durch die Einströmöffnung einströmenden Kühlluft mittels eines die Einströmöffnung einstellbar überdeckenden Abdeckelements steuer- und/oder regelbar ist, wobei das Einstellen der Überdeckung der Einströmöffnung mittels eines thermischen Stellelements erfolgt.

### Kurze Beschreibung der Zeichnungen

Die Erfindung wird im Folgenden anhand der in der Zeichnung dargestellten Ausführungsbeispiele näher erläutert, ohne dass eine Beschränkung der Erfindung erfolgt. Es zeigen:
- Figur 1: einen Ausschnitt aus einer Kühlvorrichtung zur Kühlung eines elektronischen Steuergeräts mit einer in einem Gehäuse vorgesehenen Einströmöffnung für einen Kühlluftstrom und einem die Einströmöffnung einstellbar überdeckenden Abdeckelement, welches durch ein thermisches Stellelement senkrecht zu einer Hauptströmungsrichtung eines Kühlluftstroms durch die Einströmöffnung einstellbar ist, und
- Figur 2: der aus Figur 1 bekannte Ausschnitt der Kühlvorrichtung, wobei das Abdeckelement parallel zu der Hauptströmungsrichtung bewegbar ist.

### Ausführungsform(en) der Erfindung

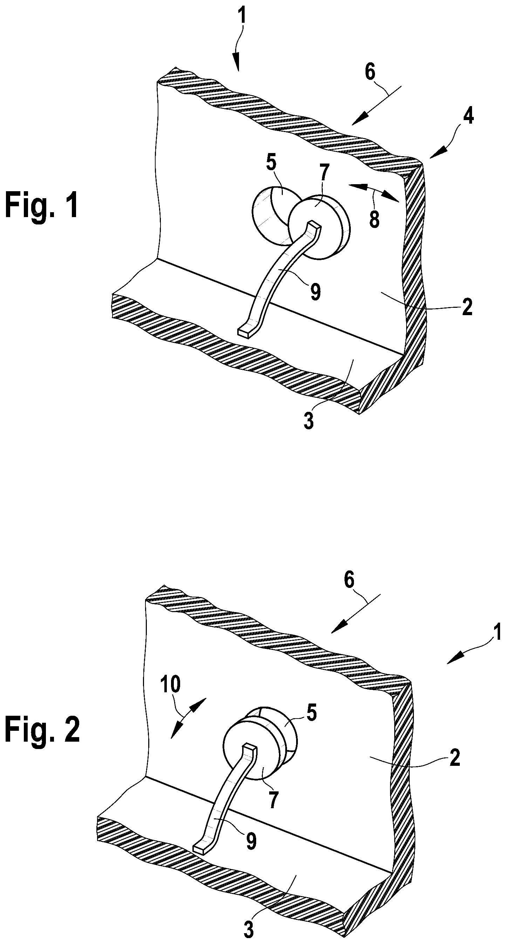

Die Figur 1 zeigt einen Ausschnitt einer Kühlvorrichtung 1 zur Kühlung eines nicht dargestellten elektronischen Steuergeräts. Zumindest abschnittsweise dargestellt sind eine Seitenwand 2 und ein Boden 3 eines Gehäuses 4 in welchem das Steuergerät angeordnet ist. Die Seitenwand 2 weist eine Einströmöffnung 5 auf, durch welche ein von einem Belüftungs- und/oder Klimatisierungssystem (nicht dargestellt) erzeugter Kühlluftstrom in das Gehäuse 4 gelangen kann. Dabei wird das Gehäuse 4 entlang eines Pfeils 6 von der Kühlluft angeströmt. Ein Abdeckelement 7 ist so angeordnet, dass die Einströmöffnung 5 einstellbar überdeckt werden kann. Mittels des Abdeckelements 7 ist also ein durch die Einströmöffnung 5 einströmender Volumenstrom der Kühlluft einstellbar. Verdeckt das Abdeckelement 7 die Einströmöffnung 5 vollständig, so kann keine Kühlluft oder lediglich ein geringer Volumenstrom in das Gehäuse 4 gelangen, während bei nicht verdeckter Einströmöffnung 5 der Kühlluftvolumenstrom hoch ist. Das Abdeckelement 7 ist zu diesem Zweck in Richtung eines Pfeils 8 verlagerbar. Das Einstellen der Überdeckung der Einströmöffnung 5, also die Bewegung des Abdeckelements 7, wird mittels eines thermischen Stellelements 9 erreicht. Dieses weist je nach seiner Temperatur eine unterschiedliche Richtungserstreckung beziehungsweise Ausdehnung auf. In dem dargestellten Beispiel ist das Stellelement 9 so ausgelegt, dass bei einer geringen Temperatur in dem Gehäuse 4 die Einströmöffnung 5 durch das Abdeckelement 7 vollständig verdeckt ist, während es bei einer hohen Temperatur vollständig geöffnet ist. Das Stellelement 9 ist an seinem einen Ende an dem Abdeckelement 7 und an seinem anderen Ende an dem Boden 3 des Gehäuses 4 befestigt. Auf diese Weise kann es eine Relativkraft zwischen Gehäuse 4 und Abdeckelement 7 ausüben und letzeres darüber verstellen. Sowohl das Abdeckelement 7 als auch das Stellelement 9 sind innerhalb des Gehäuses 4 angeordnet. Von dem elektronischen Steuergerät abgegebene und damit in dem Gehäuse 4 vorliegende Wärme kann direkt auf das Stellelement 9 übergehen. Auf diese Weise ist eine kurze Reaktionszeit bis zum Einstellen der Überdeckung der Einströmöffnung 5 realisiert.

Die Figur 2 zeigt eine alternative Ausführungsform der aus der Figur 1 bekannten Kühlvorrichtung 1. Dargestellt ist das Gehäuse 4 mit Seitenwand 2 und Boden 3, welches in Richtung des Pfeils 6 von Kühlluft angeströmt ist. Auch hier weist die Seitenwand 2 die Einströmöffnung 5 auf. Das Stellelement 9 ist auch hier an seinem einen Ende an dem Boden 3 und an seinem anderen Ende mit dem Abdeckelement 7 verbunden. Im Unterschied zu dem in der Figur 1 dargestellten Beispiel bewegt sich das Abdeckelement 7 jedoch nicht senkrecht zu der Hauptströmungsrichtung des Kühlluftstroms durch die Einströmöffnung 5, sondern parallel dazu. Das bedeutet, dass das Abdeckelement 7 in einer Geschlossenposition, also in einer Position, in welcher es die Einströmöffnung 5 vollständig abdeckt, eine zu der Seitenwand 2 parallele Erstreckung aufweist. Entfernt sich das Abdeckelement 7 von der Seitenwand 2, so ist es zumindest geringfügig gegenüber dieser angewinkelt. Die Bewegungsrichtung des Abdeckelements 7 ist durch einen Pfeil 10 angedeutet. Die Bewegung des Abdeckelements 7 erfolgt, wie vorstehend beschrieben, mittels des Stelleelements 9.

## Patentansprüche

1. Elektronisches Steuergerät für ein Kraftfahrzeug, welches in einem Gehäuse (4) mit mindestens einer Einströmöffnung (5) für einen von einem Belüftungs- und/oder Klimatisierungssystem erzeugten Kühlluftstrom angeordnet ist, wobei der Volumenstrom der durch die Einströmöffnung (5) einströmenden Kühlluft mittels eines die Einströmöffnung (5) einstellbar überdeckenden Abdeckelements (7) steuer- und/oder regelbar ist, wobei das Einstellen der Überdeckung der Einströmöffnung (5) mittels eines thermischen Stellelements (9) erfolgt, wobei das thermische Stellelement einen Werkstoff aufweist, welcher sich mit sich ändernder Temperatur verformt, wobei die für die Betätigung des thermischen Stellelements (9) erforderliche Wärme über eine Verlustleistung des elektronischen Steuergeräts entsteht, wobei das Abdeckelement (7) derart gesteuert und/oder geregelt wird, dass das elektronische Steuergerät nur dann mit Kühlluft versorgt wird, wenn das elektronische Steuergerät Kühlbedarf aufweist.

2. Elektronisches Steuergerät nach Anspruch 1, **dadurch gekennzeichnet, dass** eine Bewegungsrichtung (6,10) des Abdeckelements (7) zum Einstellen der Überdeckung senkrecht oder parallel zu einer Hauptströmungsrichtung des Kühlluftstroms, insbesondere durch die Einströmöffnung (5), vorgesehen ist.

3. Elektronisches Steuergerät nach einem der vorhergehenden Ansprüche, **dadurch gekennzeichnet, dass** das Abdeckelement (7) und/oder das thermische Stellelement (9) innerhalb des Gehäuses (4) angeordnet sind.

4. Elektronisches Steuergerät nach einem der vorhergehenden Ansprüche, **dadurch gekennzeichnet, dass** das thermische Stellelement (9), insbesondere wärmeleitfähig, mit dem Gehäuse (4) und/oder Steuergerät verbunden und/oder an dem Gehäuse (4) und/oder Steuergerät befestigt ist.

5. Elektronisches Steuergerät nach einem der vorhergehenden Ansprüche, **dadurch gekennzeichnet, dass** das Abdeckelement (7) eine Klappe oder ein Schieber ist.

6. Elektronisches Steuergerät nach einem der vorhergehenden Ansprüche, **dadurch gekennzeichnet, dass** das thermische Stellelement (9) eine zum Einstellen der Überdeckung verwendete temperaturabhängige Deformation aufweist.

7. Elektronisches Steuergerät nach einem der vorhergehenden Ansprüche, **dadurch gekennzeichnet, dass** das thermische Stellelement (9) eine vorbestimmbare Charakteristik zum zumindest teilweisen Öffnen oder Verschließen der Einströmöffnung (5) mit dem Abdeckelement (7) aufweist.

8. Elektronisches Steuergerät nach einem der vorhergehenden Ansprüche, **dadurch gekennzeichnet, dass** das thermische Stellelement (9) ein Thermobimetall, eine Formgedächtnislegierung oder einen Dehnstoff aufweist oder daraus besteht.

9. Elektronisches Steuergerät nach einem der vorhergehenden Ansprüche, **dadurch gekennzeichnet, dass** das Gehäuse (4) von dem Kühlluftstrom umströmt ist.

## Claims

1. Electronic control unit for a motor vehicle which is arranged in a housing (4) with at least one inflow opening (5) for a cooling air flow which is generated by a ventilation and/or air-conditioning system, wherein the volume flow of the cooling air which flows in through the inflow opening (5) can be open-loop and/or closed-loop controlled by means of a cover element (7) which covers the inflow opening (5) in an adjustable fashion, wherein the adjustment of the covering of the inflow opening (5) is carried out by means of a thermal actuator element (9), wherein the thermal actuator element has a material which deforms with a changing temperature, wherein the heat which is necessary to activate the thermal actuator element (9) is produced by means of a power loss of the electronic control unit, wherein the cover element (7) is open-loop and/or closed-loop controlled in such a way that the electronic control unit is supplied with cooling air only when the electronic control unit has a need for cooling.

2. Electronic control unit according to Claim 1, **characterized in that** a direction of movement (6, 10) of the cover element (7) is provided for adjusting the covering perpendicularly or in parallel with respect to a main direction of flow of the cooling air flow, in particular through the inflow opening (5).

3. Electronic control unit according to one of the preceding claims, **characterized in that** the cover element (7) and/or the thermal actuator element (9) are arranged inside the housing (4).

4. Electronic control unit according to one of the preceding claims, **characterized in that** the thermal actuator element (9) is connected, in particular in a thermally conductive fashion, to the housing (4) and/or control unit and/or is attached to the housing (4) and/or the control unit.

5. Electronic control unit according to one of the preceding claims, **characterized in that** the cover element (7) is a flap or a slider.

6. Electronic control unit according to one of the preceding claims, **characterized in that** the thermal actuator element (9) has temperature-dependent deformation which is used to adjust the covering.

7. Electronic control unit according to one of the preceding claims, **characterized in that** the thermal actuator element (9) has a predeterminable characteristic for at least partially opening or closing the inflow opening (5) with the cover element (7).

8. Electronic control unit according to one of the preceding claims, **characterized in that** the thermal actuator element (9) is a thermo-bimetal, a shape memory alloy or an expandable material or is composed thereof.

9. Electronic control unit according to one of the preceding claims, **characterized in that** the cooling air flow flows around the housing (4).

## Revendications

1. Appareil de commande électronique destiné à un véhicule automobile, qui est disposé dans un boîtier (4) comportant au moins une ouverture d'admission (5) destinée à un flux d'air de refroidissement produit par un système d'aération et/ou de climatisation, dans lequel le débit volumique de l'air de refroidissement admis par l'intermédiaire de l'ouverture d'amission (5) peut être commandé et/ou réglé au moyen d'un élément de recouvrement (7) recouvrant de manière réglable l'ouverture d'admission (5), dans lequel le réglage du dispositif de recouvrement de l'ouverture d'admission (5) s'effectue au moyen d'un élément de réglage thermique (9), dans lequel l'élément de réglage thermique comporte un matériau qui se déforme en fonction des variations de température, dans lequel la chaleur nécessaire à l'actionnement de l'élément de réglage thermique (9) est produite par une dissipation de puissance de l'appareil de commande électronique, dans lequel l'élément de recouvrement (7) est commandé et/ou régulé de manière à ce que l'appareil de commande électronique ne soit alimenté en air de refroidissement que lorsque l'appareil de commande électronique doit être refroidi.

2. Appareil de commande électronique selon la revendication 1, **caractérisé en ce qu'**il est prévu un dispositif de déplacement (6, 10) de l'élément de recouvrement (7) pour régler le recouvrement perpendiculairement ou parallèlement à une direction d'écoulement principale du flux d'air de refroidissement, notamment à travers l'ouverture d'amission (5).

3. Appareil de commande électronique selon l'une quelconque des revendications précédentes, **caractérisé en ce que** l'élément de recouvrement (7) et/ou l'élément de réglage thermique (9) est/sont disposé(s) à l'intérieur du boîtier (4).

4. Appareil de commande électronique selon l'une quelconque des revendications précédentes, **caractérisé en ce que** l'élément de réglage thermique (9) est relié, notamment de manière thermiquement conductrice, au boîtier (4) et/ou à l'appareil de commande et/ou est fixé au boîtier (4) et/ou à l'appareil de commande.

5. Appareil de commande électronique selon l'une quelconque des revendications précédentes, **caractérisé en ce que** l'élément de recouvrement (7) est un volet ou un coulisseau.

6. Appareil de commande électronique selon l'une quelconque des revendications précédentes, **caractérisé en ce que** l'élément de réglage thermique (9) présente une déformation dépendant de la température, utilisée pour le réglage du recouvrement.

7. Appareil de commande électronique selon l'une quelconque des revendications précédentes, **caractérisé en ce que** l'élément de réglage thermique (9) présente une caractéristique pouvant être déterminée à l'avance pour l'ouverture ou la fermeture au moins partielle de l'ouverture d'admission (5) au moyen de l'élément de recouvrement (7).

8. Appareil de commande électronique selon l'une quelconque des revendications précédentes, **caractérisé en ce que** l'élément de réglage thermique (9) comporte un bilame, un alliage à mémoire de forme ou un matériau de dilatation ou est constitué de ceux-ci.

9. Appareil de commande électronique selon l'une quelconque des revendications précédentes, **caractérisé en ce que** le boîtier (4) est plongé dans le flux d'air de refroidissement.
